# EUROPEAN PATENT SPECIFICATION

(11) **EP 3 598 860 B1**
(45) Date of publication and mention of the grant of the patent: **19.07.2023**
(21) Application number: 18184499.4
(22) Date of filing: 19.07.2018
(51) Int. Cl.: H05K 7/20

(54) **COOLING OF POWER ELECTRONICS UNITS**
KÜHLUNG VON LEISTUNGSELEKTRONIKEINHEITEN
REFROIDISSEMENT D'UNITÉS ÉLECTRONIQUES DE PUISSANCE

(43) Date of publication of application: 22.01.2020
(73) Proprietor: ABB Schweiz AG, 5400 Baden (CH)
(72) Inventor: Salis, Pietro, 8953 Dietikon (CH); Casty, Mathias, 5210 Windisch (CH); Blunschi, Gabriel, 5412 Gebenstorf (CH); Starz, Armin, 4132 Muttenz (CH)
(74) Representative: Qip Patentanwälte Dr. Kuehn & Partner mbB

(56) References cited:
- US-A1- 2012 279 686
- US-A1- 2015 109 728
- US-A1- 2015 114 021

## Description

### FIELD OF THE INVENTION

The invention relates to the field of cooling of components of electrical converters. In particular, the invention relates to a power electronics unit and a power electronics arrangement.

### BACKGROUND OF THE INVENTION

Many electrical converters are assembled of so called power electronic building blocks, which in the following also will be called power electronics units. Such blocks or units may carry power semiconductor modules that are responsible for switching currents through the converter.

A liquid cooling system for such an electrical converter may comprise many pipes and hoses, which interconnect the power electronics units with each other and with further parts, such as heat exchangers, a pump, etc.

A power electronics unit may comprise a liquid cooled cooling body with a cooling channel that is connected with an inlet on one end of the cooling body with a supply line and with an outlet on another end with a return line. This may result in an inhomogeneous temperature distribution along the cooling body. It may be that a power semiconductor near the outlet is less cooled than a power semiconductor module near the inlet, which may degrade the lifetime of the power electronics unit, and the system performance may be limited by this module.

The power electronics units may be assembled with each other via a mechanical support structure, which is independent of the cooling system. For example, the power electronics units may be stacked onto each other and interconnected via the mechanical support structure. Specially designed pipes may be arranged at both ends of the stack and may be interconnected via hoses with the power electronics units.

US 2012/0279686 A1 shows a cooling system for electronic racks, in which electronic systems are provided, which are cooled via manifolds. Furthermore, a cooling plate is shown, which has reciprocating cooling lines and to which electronic components are attached.

US 2015/109 728 A1 relates to a cooled electronic system, wherein a field-replaceable bank of electronic components is cooled by an apparatus which includes an enclosure at least partially surrounding and forming a compartment about the electronic components, a fluid disposed within the compartment, and a heat sink associated with the enclosure. The field-replaceable bank extends, in part, through the enclosure to facilitate operative docking of the electronic components into one or more respective receiving sockets of the electronic system.

US 2015/0 114 021 A1 shows a refrigeration apparatus with a cooling plate made of an extrusion profile.

### DESCRIPTION OF THE INVENTION

It is an objective of the invention to enhance the active cooling of a power electronics unit and to reduce the number of parts of a power electronics unit. Further objectives of the invention are to reduce the size of a cooling system of an electrical converter and to provide a compact and economic electrical converter.

These objectives are achieved by the subject-matter of independent claim 1. Further exemplary embodiments are evident from the dependent claims and the following description.

A first aspect of the invention relates to a power electronics unit, which may be a device assembled of power electronic components, such as power semiconductor devices and their electrical and mechanical interconnection. The power electronics arrangement also may be called power electronics building block (PEBB). The term "power electronics" may refer to devices adapted for processing current of more than 100 V and/or more than 10 A.

The power electronics unit may be employed in an electrical converter, such as a traction converter. A traction converter may be a converter in a train or tram, which is used for converting a current from a catenary line into a current supplied to electrical motors driving the train or tram. The power electronics unit comprises a longitudinal cooling plate with a cooling channel for a cooling fluid, the cooling plate having two opposite side faces, between which the cooling channel is arranged and a plurality of power semiconductor modules attached to at least one side face of the cooling plate.

The cooling plate may be made of two metal plates, which are attached to each other at side faces. One or two of the metal plates may be machined for generating the cooling channel. The cooling plate and/or the metal plates may be made of aluminium.

Longitudinal may mean that the cooling plate, which may have a flat body, has an extension in a longitudinal direction, which extension is longer than an extension in a cross direction. The cross direction may be orthogonal to a longitudinal direction of the cooling plate. The cooling plate further may have an extension plane and/or central plane, which is in parallel with the longitudinal direction and the cross direction.

A power semiconductor module may be a device carrying one or more power semiconductor chips, such as diodes, transistors and/or thyristors, which are electrically and mechanically interconnected with each other. Furthermore, a power semiconductor module may comprise a cooling body that is in contact with the semiconductor chips for heat exchange. The power semiconductor module may be attached to the cooling plate of the power electronics unit via its cooling body, which may be in area contact with the cooling plate.

The cooling fluid may be a cooling liquid, such as water. The cooling channel may be tight with respect to the cooling fluid.

Furthermore, an inlet of the cooling channel and an outlet of the cooling channel are arranged at a first longitudinal end of the cooling plate and the cooling channel reciprocates between the first longitudinal end and an opposite second longitudinal end of the cooling plate. An end of the cooling plate may be a part of the cooling plate that comprises an edge of the cooling plate and that is optionally smaller than 20% of the length of the longitudinal extension. The cooling channel may be arranged below and/or between power semiconductor modules.

In other words, cooling fluid flows into the cooling plate at the same end of the cooling plate, where it also leaves the cooling plate. In such a way, the cooling channel may run below the power semiconductor modules from the first end with the inlet and the outlet to the second end and from there back. Thus, all semiconductor modules may be cooled homogenously.

An average temperature of the cooling fluid at each power semiconductor module may be the same. The average temperature may be the average of the temperature of the cooling fluid flowing in one direction and the temperature of the cooling fluid flowing in the opposite direction. This may result in a more homogenous temperature distribution in the cooling plate.

There are several possibilities, how sections of the cooling channel inside the cooling plate may be arranged to reciprocate between the ends of the cooling plate. In general, the sections run from the first end of the cooling plate to the second end and back to the first end. The sections may split up and join. The sections may run in parallel and/or oblique with each other. The sections may have the same diameter and/or may have different diameters.

According to an embodiment of the invention, a section of the cooling channel, which runs from the first longitudinal end to the second longitudinal end, is directly connected with a section of the cooling channel, which runs from the second longitudinal end to the first longitudinal end. Directly connected may mean that there are no further sections between the two sections. A direction of a section may also refer to a flow direction of the cooling fluid inside the section.

According to an embodiment of the invention, sections of the cooling channel, which are arranged in the cooling plate one after the other in a cross direction, run alternatingly from the first longitudinal end to the second longitudinal end and from the second longitudinal end to the first longitudinal end.

It may be that directly connected anti-parallel sections are arranged next to each other with respect to the cross direction of the cooling plate. It also may be that directly connected anti-parallel sections are separated by other sections.

According to an embodiment of the invention, the cooling channel splits into several sections, which run parallel to each other from the first longitudinal end to the second longitudinal end and/or vice versa. These sections and/or section directly connected to these sections also may join into one section and/or into the outlet.

According to an embodiment of the invention, sections of the cooling channel, which run parallel to a longitudinal direction of the cooling plate, are connected with U-turns. Directly connected sections may be connected with a U-tum, which may be considered as part of the section. These U-turns may be located in and/or near the ends of the cooling plate. Power semiconductor modules may be arranged only between and/or below parts and/or sections of the cooling channel, which run parallel and/or anti-parallel to the longitudinal direction of the cooling plate.

According to an embodiment of the invention, U-turns interconnection sections of the cooling channel, which run into opposite directions, are nested into each other. There may be a first U-turn that is nearer to an end of the cooling plate as a second U-turn, which is separated from the end by the first U-turn.

According to an embodiment of the invention, power semiconductor modules are attached to both side faces of the cooling plate. For example, the power semiconductor modules may be attached mirror symmetric to a central plane of the cooling plate. This may reduce the space occupied by the power electronics units.

A further aspect of the invention relates to a power electronics arrangement, which may be adapted for cooling its power electronics units. The power electronics arrangement may be seen as cooling and support arrangement. The power electronics arrangement may be part of an electrical converter, such as a traction converter.

It has to be noted that features of the power electronics unit as described in the above and in the below may be features of the power electronics arrangement as described in the above and in the below, and vice versa.

According to an embodiment of the invention, the power electronics arrangement comprises at least two power electronics units as described in the above and in the following and a cooling pipe comprising a supply line and a return line for cooling fluid.

The supply line and the return line of the cooling pipe may be two separated channels in one jacket. The cooling pipe, the supply line and the return line are made in one piece.

According to an embodiment of the invention, each power electronics unit is mechanically attached to the cooling pipe via their cooling plates, wherein the inlet of each power electronics unit is connected to the supply line and the outlet of each power electronics unit is attached to the return line.

The cooling pipe is not only used for supplying and discharging of cooling fluid, but is also used for mechanically supporting the power electronics units. Using a cooling pipe as mechanical support structure may reduce the number of parts and/or the weight of the electrical converter.

The fluid connection of the cooling pipe with the power electronics units may be performed with hoses, pipes and/or couplings. A direct connection via couplings and/or pipes may be possible. It may be possible that at least a part of the mechanical support is provided by couplings and/or pipes interconnecting the power electronics unit with the cooling pipe.

According to an embodiment of the invention, the inlet and/or the outlet are connected to the cooling pipe via a hose. A pipe, such as the cooling pipe, may be a rigid member, which may be made of metal. A hose may be a flexible member, which may be made of rubber.

According to an embodiment of the invention, the inlet and/or the outlet are connected to the cooling pipe via a plug coupling. A plug coupling and/or fast coupling may be plugged onto a corresponding coupling of the cooling pipe. This may shorten a time for exchanging a defect power electronics unit.

According to an embodiment of the invention, the cooling plate of each power electronics unit is attached to a support member, which is attached to the cooling pipe. The support member may be a metal part, which may be screwed or otherwise attached to the cooling pipe and the power electronics unit.

According to an embodiment of the invention, two power electronics units are attached to the cooling pipe, such that they are rotated by 180° with respect to each other. The power electronics units may be designed symmetrically with respect to each other. The power electronics units may be attached to two opposite sides of the cooling pipe. This may further reduce the space occupied by the power electronics units and its support structure.

There are several possibilities, how the power electronics units are aligned with respect to the cooling pipe, which may be a straight member.

According to an embodiment of the invention, power electronics units are attached to the cooling pipe, such that an extension plane of each power electronics unit is orthogonal to an extension direction of the cooling pipe. The power electronics units may be stacked on one or two sides of the cooling pipe.

According to an embodiment of the invention, power electronics units are attached to the cooling pipe, such that an extension plane of each power electronics unit is parallel to an extension direction of the cooling pipe. This may result in a rather flat design of the power electronics arrangement.

According to an embodiment of the invention, the cooling pipe is made of an extrusion profile, which may be made of aluminium. The cooling pipe may be straight and/or may be composed of straight sections. Due to the extrusion profile, a project specific construction for cooling pipes may be obsolete, which may reduce costs. A cooling pipe made of an extrusion profile is scalable in length and any number of power electronics units may be arranged one after the other on one or two sides of the cooling pipe.

With the power electronics unit and the power electronics arrangement, a uniform and standardized design for fluid cooled converters may be provided. In particular, traction converters for roof mounting, underfloor mounting and/or machine room mounting may be designed, which have a uniform mechanical concept.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a cross section through a power electronics unit according to an embodiment of the invention.
Fig. 2A schematically shows a top view of a power electronics unit according to an embodiment of the invention.
Fig. 2B schematically shows a top view of a power electronics unit according to an embodiment of the invention.
Fig. 2C schematically shows a top view of a power electronics unit according to an embodiment of the invention.
Fig. 3 schematically shows a cross section through a power electronics arrangement according to an embodiment of the invention.
Fig. 4 schematically shows a cross section through a power electronics arrangement according to an embodiment of the invention.
Fig. 5 schematically shows a cross section through a power electronics arrangement according to an embodiment of the invention.
Fig. 6 schematically shows a side view of a power electronics arrangement according to an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

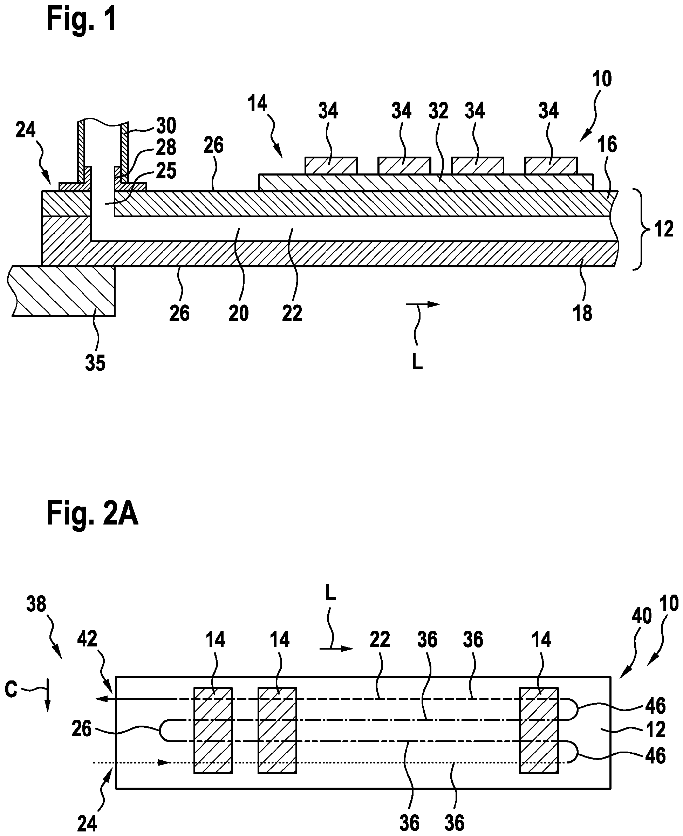

Fig. 1 shows a power electronics unit 10, which comprises a substantially flat cooling plate 12, onto which power semiconductor modules 14 are attached (only one is shown). The cooling plate 12 is composed of two metal plates 16, 18, which are attached to each other with inner side faces. In one of the metal plates 18, a recess 20 is machined for generating a cooling channel 22 in the cooling plate 12.

An inlet 24 of the cooling channel 22 may be provided by a hole 25 towards a side face 26 of the cooling plate 12, onto which a connection member 28 may be provided. The connection member 28 and/or the inlet 24 may be connected to a hose 30 for supplying cooling fluid, such as water to the cooling plate 12. An outlet of the cooling channel 22 may be designed like the inlet 24.

The power semiconductor modules 14 may be attached to one side face 26 of the cooling plate 12 or to both side faces 26 of the cooling plate 12. Each power semiconductor module 14 comprises a cooling body 32, such as a metal plate, which is attached to a side face 26 of the cooling plate 12. Power semiconductor devices 34 of the power semiconductor module 14 are in contact with the cooling body 32 for heat exchange.

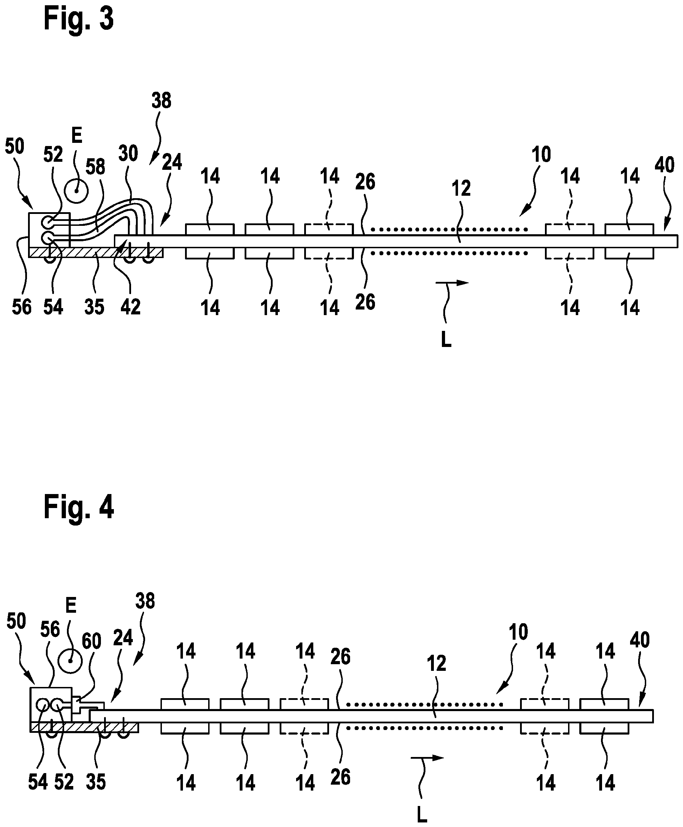

Fig. 1 furthermore shows a support member 35 for mechanically attaching the power electronics unit 10 via the cooling plate 12 to a cooling pipe, which will be described in more detail with respect to Fig. 3 to 6.

Fig. 2A to 2C show that cooling plate 12 has a longitudinal body with two longitudinal ends 38, 40. For example, the cooling plate 12 may be substantially rectangular. The power semiconductor modules 14 may be arranged in one or more rows on the cooling plate 12 along a longitudinal direction L.

Fig. 2A to 2C furthermore show that the inlet 24 and the outlet 42 of the cooling channel both are arranged at the first end 38. The cooling channel 22 reciprocates between the first end 38 and the second end 40 and/or is divided into sections 36, which run substantially parallel to the longitudinal direct L. All these sections 36 are connected via U-turns 46.

In Fig. 2A to Fig. 2C, the temperature of the cooling fluid is indicated via dots and dashes. As longer the dashes as higher the temperature.

In Fig. 2A, sections 36 directly connected via U-turns 46 are arranged one after the other in a cross direction C. Anti-parallel sections 36 are neighboring.

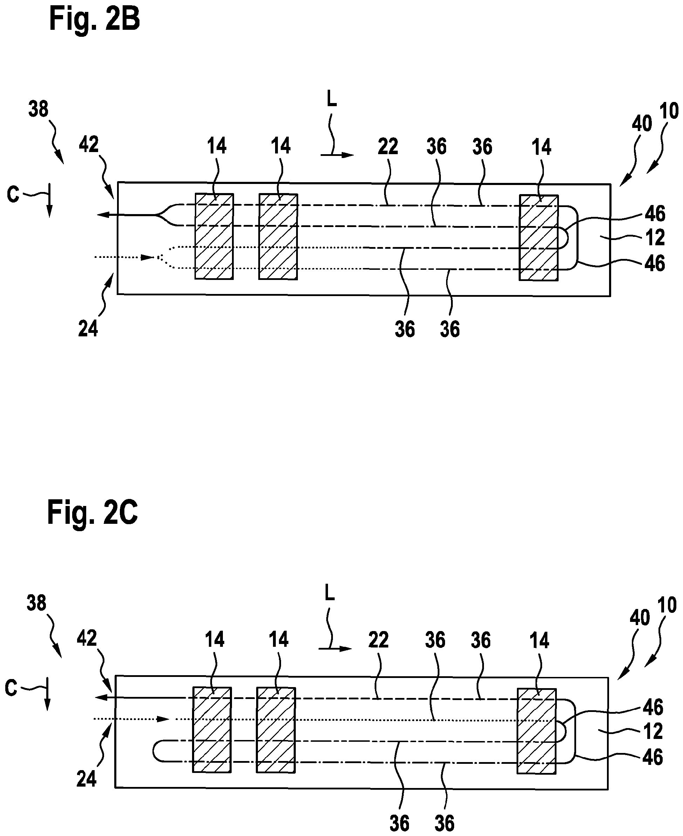

In Fig. 2B, the inlet 24 splits into two sections 36, which are running parallel to each other along the longitudinal direction L towards the second end 40. These two sections 36 are directly connected via two nested U-turns 46 with two sections 36, which are running parallel to each other along the longitudinal direction L back to the first end 38. There, the two sections join into the outlet 42.

In Fig. 2C, two neighboring sections 36 directly connected with the inlet 24 and the outlet 42 are running along the longitudinal direction L towards the second end 40. These two sections 36 are directly connected via two nested U-turns 46 with two sections 36, which are running parallel to each other along the longitudinal direction L back to the first end 38, where they are interconnected via a U-turn 46.

It has to be noted that the cooling plates 12 of the power electronics units 10 of Fig. 1 and Fig. 3 to 6 may be designed like the ones shown in Fig. 2A and 2B. Furthermore, all the power electronics unit 10 shown in Fig. 3 to 6 may be designed like the power electronics unit 10 of Fig. 1.

Fig. 3 shows a power electronics arrangement 48, which comprises a power electronics unit 10 mechanically connected to a cooling pipe 50. The power electronics unit 10 comprises power semiconductor modules 14 that are attached symmetrically to both side faces 26 of the cooling plate 12.

The cooling plate 12 of the power electronics unit 10 is attached at the first end 38 to a support member 35, which may be a metal plate. For example, the support member 35 is screwed to the cooling plate 12 opposite to the inlet 24 and outlet 42. On its other end, the support member 35 is attached to the cooling pipe 50, which is also adapted for mechanically supporting the power electronics unit 10. According to the invention, the cooling pipe 50 is made from an extrusion and comprises a supply line 52 and a return line 54, which may run substantially parallel to an extension direction E of the cooling pipe 50. The supply line 52, the return line 54 and an optional jacket 56 are made of one piece optionally of aluminium. The support member 35 may be attached, for example screwed, to the jacket 56.

Fig. 3 shows that the inlet 24 of the power electronics unit 10 is connected via the hose 30 with an outlet of the cooling pipe 50, which is interconnected with the supply line 52. Furthermore, the outlet 42 of the power electronics unit 10 is connected via a second hose 58 with an inlet of the cooling pipe 50, which is interconnected with the return line 54.

The power electronics unit 10 of Fig. 3 is solely mechanically connected to the cooling pipe 50, for example via the support member 35.

Like in Fig. 3, in Fig. 4, the power electronics unit 10 is connected via a support member 35 to the cooling pipe 50. However, in Fig. 4, the inlet 24 is connected via a plug coupling 60 with the cooling pipe 50. The plug coupling 60 may be a fast coupling that automatically closes, when it is disconnected from the cooling pipe 50. The plug coupling 60 may be connected via a hose or a pipe with the inlet 24.

Analogously to the inlet 24, also the outlet 42 may be connected via a plug coupling with the cooling pipe 50.

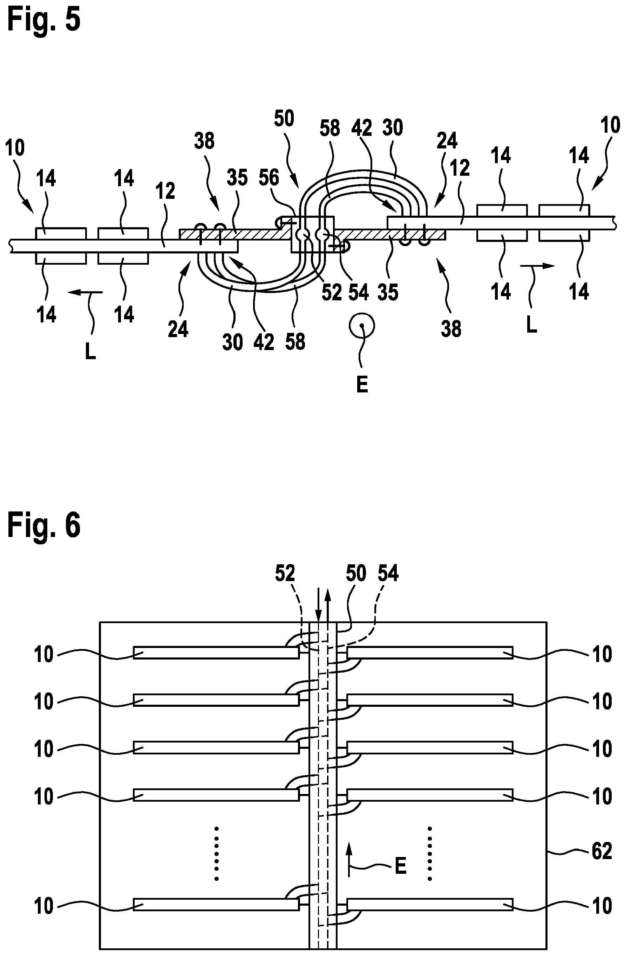

Fig. 5 shows a power electronics arrangement 48, which comprises two power electronics units 10, which are connected to a cooling pipe 50. Each of the power electronics units 10 may be connected to the cooling pipe 50 as in Fig. 3 (as shown) or as in Fig. 4. The power electronics units 10 are attached to the cooling pipe 50, such that they are rotated by 180° with respect to each other.

Fig. 6 shows power electronics arrangement 48, where a plurality of power electronics units 10 are stacked with each other into two stacks arranged at two sides of the cooling pipe 50. For example, the power electronics arrangement 48 is part of an electrical converter 62, which also may comprise a controller for the power semiconductor modules 14 and/or a cooling system, which supplies the cooling pipe 50.

Also in Fig. 6, the power electronics units 10 may be connected via support members 35 with the cooling pipe 50. The fluid connection also may be made like in Fig. 3 and 4 via hoses 30, 58 and/or plug couplings 60.

In Fig. 3, 4 and 5, the power electronics units 10 are attached to the cooling pipe 50, such that an extension plane of each power electronics unit 10 is orthogonal to an extension direction E of the cooling pipe 50. In Fig. 6, the power electronics units 10 are attached to the cooling pipe 50, such that an extension plane of each power electronics unit 10 is parallel to an extension direction E of the cooling pipe 50.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention within the limits of the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: power electronics unit
- 12: cooling plate
- 14: power semiconductor module
- 16: metal plate
- 18: metal plate
- 20: recess
- 22: cooling channel
- 24: inlet
- 25: hole
- 26: side face
- 28: connection member
- 30: hose
- 32: cooling body
- 34: power semiconductor device
- 35: support member
- 36: section of cooling channel
- 38: first end
- 40: second end
- 42: outlet
- 46: U-turn
- 48: power electronics arrangement
- 50: cooling pipe
- 52: supply line
- 54: return line
- 56: jacket
- 58: hose
- 60: plug coupling
- 62: electrical converter
- L: longitudinal direction of cooling plate
- C: cross direction of cooling plate
- E: extension direction of cooling pipe

## Claims

1. A power electronics arrangement (48), comprising:
at least two power electronics units (10);
a cooling pipe (50) comprising a supply line (52) and a return line (54) for cooling fluid;
wherein an inlet (24) of each power electronics unit (10) is connected to the supply line (52) and an outlet (42) of each power electronics unit (10) is attached to the return line (54);
wherein each power electronics unit comprises a longitudinal cooling plate (12) with a cooling channel (22) for a cooling fluid, the cooling plate (12) having two opposite side faces (26), between which the cooling channel (22) is arranged;
wherein each power electronics unit comprises a plurality of power semiconductor modules (14) attached to at least one side face (26) of the cooling plate (12);
wherein the inlet (24) of the cooling channel (22) and the outlet (42) of the cooling channel (22) are arranged at a first longitudinal end (38) of the cooling plate (12);
wherein the cooling channel (22) reciprocates between the first longitudinal end (38) and an opposite second longitudinal end (40) of the cooling plate (12);
wherein each power electronics unit (10) is mechanically attached to the cooling pipe (50) via their cooling plates (12)
**characterized in that**
the power electronics arrangement (48) further comprises a support member (35), which is attached to the cooling pipe (50);
the cooling pipe (50) is made of an extrusion profile, wherein the supply line (52) and the return line (54) are made of one piece;
wherein the cooling plate (12) of each power electronics unit (10) is attached to the support member (35).

2. The power electronics arrangement (48) of claim 1,
wherein a section (36) of the cooling channel (22), which runs from the first longitudinal end (38) to the second longitudinal end (40), is directly connected with a section (36) of the cooling channel (22), which runs from the second longitudinal end (40) to the first longitudinal end (38).

3. The power electronics arrangement (48) of claim 1 or 2,
wherein sections (36) of the cooling channel (22), which are arranged in the cooling plate (12) one after the other in a cross direction (C), run alternatingly from the first longitudinal end (38) to the second longitudinal end (40) and from the second longitudinal end (40) to the first longitudinal end (38).

4. The power electronics arrangement (48) of one of the previous claims,
wherein the cooling channel (22) splits into several sections (36), which run parallel to each other from the first longitudinal end (38) to the second longitudinal end (40) and/or vice versa.

5. The power electronics arrangement (48) of one of the previous claims,
wherein sections (36) of the cooling channel (22), which run parallel to a longitudinal direction (L) of the cooling plate (12), are connected with U-turns (46).

6. The power electronics arrangement (48) of one of the previous claims,
wherein U-turns (46) interconnecting sections (36) of the cooling channel (22), which run into opposite directions, are nested into each other.

7. The power electronics arrangement (48) of one of the previous claims,
wherein power semiconductor modules (14) are attached to both side faces (26) of the cooling plate (12).

8. The power electronics arrangement (48) of one of the previous claims,
wherein the inlet (24) and/or the outlet (42) are connected to the cooling pipe (50) via a hose (30, 58).

9. The power electronics arrangement (48) of one of the previous claims,
wherein the inlet (24) and/or the outlet (42) are connected to the cooling pipe (50) via a plug coupling (60).

10. The power electronics arrangement (48) of one of the previous claims,
wherein two power electronics units (10) are attached to the cooling pipe (50), such that they are rotated by 180° with respect to each other.

11. The power electronics arrangement (48) of one of the previous claims,
wherein power electronics units (10) are attached to the cooling pipe (50), such that an extension plane of each power electronics unit (10) is orthogonal to an extension direction (E) of the cooling pipe (50).

12. The power electronics arrangement (48) of one of the previous claims,
wherein power electronics units (10) are attached to the cooling pipe (50), such that an extension plane of each power electronics unit (10) is parallel to an extension direction (E) of the cooling pipe (50).

## Patentansprüche

1. Leistungselektronikanordnung (48), umfassend:
mindestens zwei Leistungselektronikeinheiten (10);
ein Kühlrohr (50) mit einer Vorlaufleitung (52) und einer Rücklaufleitung (54) für Kühlflüssigkeit;
wobei ein Einlass (24) jeder Leistungselektronikeinheit (10) mit der Vorlaufleitung (52) verbunden ist und ein Auslass (42) jeder Leistungselektronikeinheit (10) an die Rücklaufleitung (54) angeschlossen ist;
wobei jede Leistungselektronikeinheit eine längliche Kühlplatte (12) mit einem Kühlkanal (22) für eine Kühlflüssigkeit umfasst, wobei die Kühlplatte (12) zwei gegenüberliegende Seitenflächen (26) aufweist, zwischen denen der Kühlkanal (22) angeordnet ist;
wobei jede Leistungselektronikeinheit eine Vielzahl von Leistungshalbleitermodulen (14) umfasst, die an mindestens einer Seitenfläche (26) der Kühlplatte (12) angebracht sind;
wobei der Einlass (24) des Kühlkanals (22) und der Auslass (42) des Kühlkanals (22) an einem ersten Längsende (38) der Kühlplatte (12) angeordnet sind;
wobei sich der Kühlkanal (22) zwischen dem ersten Längsende (38) und einem gegenüberliegenden zweiten Längsende (40) der Kühlplatte (12) hin und her bewegt;
wobei jede Leistungselektronikeinheit (10) über ihre Kühlplatten (12) mechanisch an dem Kühlrohr (50) angebracht ist;
**dadurch gekennzeichnet, dass**
die Leistungselektronikanordnung (48) ferner ein Trägerelement (35) umfasst, das an dem Kühlrohr (50) angebracht ist;
das Kühlrohr (50) aus einem Extrusionsprofil gefertigt ist, wobei die Vorlaufleitung (52) und die Rücklaufleitung (54) aus einem Stück gefertigt sind;
wobei die Kühlplatte (12) jeder Leistungselektronikeinheit (10) an dem Trägerelement (35) angebracht ist.

2. Leistungselektronikanordnung (48) gemäß Anspruch 1,
wobei ein Abschnitt (36) des Kühlkanals (22), der von dem ersten Längsende (38) zu dem zweiten Längsende (40) verläuft, direkt mit einem Abschnitt (36) des Kühlkanals (22) verbunden ist, der von dem zweiten Längsende (40) zu dem ersten Längsende (38) verläuft.

3. Leistungselektronikanordnung (48) gemäß Anspruch 1 oder 2,
wobei Abschnitte (36) des Kühlkanals (22), die in der Kühlplatte (12) in einer Querrichtung (C) hintereinander angeordnet sind, abwechselnd vom ersten Längsende (38) zum zweiten Längsende (40) und vom zweiten Längsende (40) zum ersten Längsende (38) verlaufen.

4. Leistungselektronikanordnung (48) gemäß einem der vorhergehenden Ansprüche,
wobei sich der Kühlkanal (22) in mehrere Abschnitte (36) aufteilt, die parallel zueinander vom ersten Längsende (38) zum zweiten Längsende (40) und/oder umgekehrt verlaufen.

5. Leistungselektronikanordnung (48) gemäß einem der vorhergehenden Ansprüche,
wobei Abschnitte (36) des Kühlkanals (22), die parallel zu einer Längsrichtung (L) der Kühlplatte (12) verlaufen, mit U-Bögen (46) verbunden sind.

6. Leistungselektronikanordnung (48) gemäß einem der vorhergehenden Ansprüche,
wobei U-Bögen (46), die in entgegengesetzte Richtungen verlaufende Abschnitte (36) des Kühlkanals (22) miteinander verbinden, ineinander verschachtelt sind.

7. Leistungselektronikanordnung (48) gemäß einem der vorhergehenden Ansprüche,
wobei Leistungshalbleitermodule (14) an beiden Seitenflächen (26) der Kühlplatte (12) angebracht sind.

8. Leistungselektronikanordnung (48) gemäß einem der vorhergehenden Ansprüche,
wobei der Einlass (24) und/oder der Auslass (42) über einen Schlauch (30, 58) mit dem Kühlrohr (50) verbunden sind.

9. Leistungselektronikanordnung (48) gemäß einem der vorhergehenden Ansprüche,
wobei der Einlass (24) und/oder der Auslass (42) über eine Steckkupplung (60) mit dem Kühlrohr (50) verbunden sind.

10. Leistungselektronikanordnung (48) gemäß einem der vorhergehenden Ansprüche,
wobei zwei Leistungselektronikeinheiten (10) so an dem Kühlrohr (50) angebracht sind, dass sie um 180° gegeneinander gedreht sind.

11. Leistungselektronikanordnung (48) gemäß einem der vorhergehenden Ansprüche,
wobei Leistungselektronikeinheiten (10) so an dem Kühlrohr (50) angebracht sind, dass eine Erstreckungsebene jeder Leistungselektronikeinheit (10) orthogonal zu einer Erstreckungsrichtung (E) des Kühlrohrs (50) verläuft.

12. Leistungselektronikanordnung (48) gemäß einem der vorhergehenden Ansprüche,
wobei Leistungselektronikeinheiten (10) so an dem Kühlrohr (50) angebracht sind, dass eine Erstreckungsebene jeder Leistungselektronikeinheit (10) parallel zu einer Erstreckungsrichtung (E) des Kühlrohrs (50) verläuft.

## Revendications

1. Agencement d'électronique de puissance (48), comprenant :
au moins deux unités d'électronique de puissance (10) ;
un tuyau de refroidissement (50) comprenant une ligne d'alimentation (52) et une ligne de retour (54) pour un fluide frigorigène ;
dans lequel une entrée (24) de chaque unité d'électronique de puissance (10) est raccordée à la ligne d'alimentation (52) et une sortie (42) de chaque unité d'électronique de puissance (10) est attachée à la ligne de retour (54) ;
dans lequel chaque unité d'électronique de puissance comprend une plaque de refroidissement longitudinale (12) avec un anal de refroidissement (22) pour un fluide frigorigène, la plaque de refroidissement (12) ayant deux faces latérales opposées (26), entre lesquelles le canal de refroidissement (22) est disposé ;
dans lequel chaque unité d'électronique de puissance comprend une pluralité de modules semi-conducteurs de puissance (14) attachés à au moins une face latérale (26) de la plaque de refroidissement (12) ;
dans lequel l'entrée (24) du canal de refroidissement (22) et la sortie (42) du canal de refroidissement (22) sont disposées à une première extrémité longitudinale (38) de la plaque de refroidissement (12) ;
dans lequel le canal de refroidissement (22) effectue un va-et-vient entre la première extrémité longitudinale (38) et une deuxième extrémité longitudinale opposée (40) de la plaque de refroidissement (12) ;
dans lequel chaque unité d'électronique de puissance (10) est attachée mécaniquement au tuyau de refroidissement (50) par le biais de leurs plaques de refroidissement (12),
**caractérisé en ce que**
l'agencement d'électronique de puissance (48) comprend en outre un élément de support (35), qui est attaché au tuyau de refroidissement (50) ;
le tuyau de refroidissement (50) est constitué d'un profilé d'extrusion, dans lequel la ligne d'alimentation (52) et la ligne de retour (54) sont fabriquées d'une seule pièce ;
dans lequel la plaque de refroidissement (12) de chaque unité d'électronique de puissance (10) est attachée à l'élément de support (35).

2. Agencement d'électronique de puissance (48) de la revendication 1,
dans lequel une section (36) du canal de refroidissement (22) qui va de la première extrémité longitudinale (38) à la deuxième extrémité longitudinale (40) est directement raccordée à une section (36) du canal de refroidissement (22) qui va de la deuxième extrémité longitudinale (40) à la première extrémité longitudinale (38).

3. Agencement d'électronique de puissance (48) de la revendication 1 ou 2,
dans lequel des sections (36) du canal de refroidissement (22) qui sont disposées dans la plaque de refroidissement (12) les unes après les autres dans une direction transversale (C) vont en alternance de la première extrémité longitudinale (38) à la deuxième extrémité longitudinale (40) et de la deuxième extrémité longitudinale (40) à la première extrémité longitudinale (38).

4. Agencement d'électronique de puissance (48) d'une des revendications précédentes,
dans lequel le canal de refroidissement (22) se sépare en plusieurs sections (36), qui vont parallèlement les unes aux autres de la première extrémité longitudinale (38) à la deuxième extrémité longitudinale (40) et/ou vice versa.

5. Agencement d'électronique de puissance (48) d'une des revendications précédentes,
dans lequel des sections (36) du canal de refroidissement (22) qui cheminent parallèlement à une direction longitudinale (L) de la plaque de refroidissement (12) sont raccordées à des coudes en U (46) .

6. Agencement d'électronique de puissance (48) d'une des revendications précédentes,
dans lequel des coudes en U (46) interconnectant des sections (36) du canal de refroidissement (22) qui vont dans des directions opposées sont imbriqués les uns dans les autres.

7. Agencement d'électronique de puissance (48) d'une des revendications précédentes,
dans lequel des modules semi-conducteurs de puissance (14) sont attachés aux deux faces latérales (26) de la plaque de refroidissement (12).

8. Agencement d'électronique de puissance (48) d'une des revendications précédentes,
dans lequel l'entrée (24) et/ou la sortie (42) sont raccordées au tuyau de refroidissement (50) par le biais d'un flexible (30, 58).

9. Agencement d'électronique de puissance (48) d'une des revendications précédentes,
dans lequel l'entrée (24) et/ou la sortie (42) sont raccordées au tuyau de refroidissement (50) par le biais d'un raccord enfichable (60).

10. Agencement d'électronique de puissance (48) d'une des revendications précédentes,
dans lequel deux unités d'électronique de puissance (10) sont attachées au tuyau de refroidissement (50) de telle sorte qu'elles sont tournées de 180° l'une par rapport à l'autre.

11. Agencement d'électronique de puissance (48) d'une des revendications précédentes,
dans lequel des unités d'électronique de puissance (10) sont attachées au tuyau de refroidissement (50) de telle sorte qu'un plan d'extension de chaque unité d'électronique de puissance (10) est orthogonal à une direction d'extension (E) du tuyau de refroidissement (50) .

12. Agencement d'électronique de puissance (48) d'une des revendications précédentes,
dans lequel des unités d'électronique de puissance (10) sont attachées au tuyau de refroidissement (50) de telle sorte qu'un plan d'extension de chaque unité d'électronique de puissance (10) est parallèle à une direction d'extension (E) du tuyau de refroidissement (50) .
